# EUROPEAN PATENT SPECIFICATION

(11) **EP 1 164 435 B1**
(45) Date of publication and mention of the grant of the patent: **14.12.2011**
(21) Application number: 99970175.8
(22) Date of filing: 05.10.1999
(51) Int. Cl.: G03F 7/075, G03F 7/004, H01L 21/027, C08L 83/16, H01L 21/312

(54) **PHOTOSENSITIVE POLYSILAZANE COMPOSITION AND METHOD OF FORMING PATTERNED POLYSILAZANE FILM**
FOTOEMPFINDLICHE POLYSILAZANZUSAMMENSETZUNG UND VERFAHREN ZUR HERSTELLUNG EINES MUSTERS IN EINEM POLYSILAZANFILM
COMPOSITION DE POLYSILAZANE PHOTOSENSIBLE ET PROCEDE DE FORMATION D'UNE COUCHE MINCE DE POLYSILAZANE A MOTIF

(30) Priority: 05.10.1998 JP 28269798
(43) Date of publication of application: 19.12.2001
(73) Proprietor: AZ Electronic Materials USA Corp., Somerville, NJ 08876 (US)
(72) Inventor: NAGAHARA, Tatsuro Tonen Corp. Co. Res, Dev. Lab., Iruma-gun Saitama 356-8505 (JP); MATSUO, Hideki Tonen Corp. Co. Res. Dev. Lab., Iruma-gun Saitama 356-8505 (JP); AOKI, Tomoko Tonen Corp. Co. Res. Dev. Lab., Iruma-gun Saitama 356-8505 (JP); YAMADA, Kazuhiro Tonen Corp. Co. Res. Dev. Lab., Iruma-gun Saitama 356-8505 (JP)
(74) Representative: Isenbruck, Günter
(86) International application number: PCT/JP1999/005498
(87) International publication number: WO 2000/020927

(56) References cited:
- JP-A- 1 203 476
- JP-A- 5 132 559
- JP-A- 9 230 600
- JP-A- 10 073 925
- JP-A- 10 079 381
- JP-A- 11 092 666
- JP-A- 62 222 246
- US-A- 4 678 688
- US-A- 4 770 974

## Description

### Technical Field

The present invention relates to a photosensitive polysilazane composition, and more particularly, to a photodecomposable polysilazane composition that is able to form a film that allows fine patterning processing by light, along with a method of forming a patterned polysilazane film and an insulating film using this composition.

### Background Art

The use of photoresists in the production of semiconductor devices is widely known. Photoresists consist of negative types, which are resistant to dissolving in developing liquid due to exposure to light, and positive types, which, conversely, easily dissolve in developing liquid due to exposure to light.

These photoresists are required to have numerous sophisticated characteristics. In particular, in the processing of semiconductor devices, which are continuing to employ increasingly fine technology, the photoresists used in that processing are required to have high resolution. In general, positive photoresists are able to achieve higher resolution than negative photoresists.

In addition, dry etching is frequently used in fine patterning of semiconductor devices, and those photoresists are also required to withstand oxygen plasma (oxygen plasma resistance).

In general, acrylic polymers and numerous other types of organic materials are used as photoresist materials. Photoresists are removed following completion of patterning (etching treatment) by ashing using oxygen plasma and/or by a suitable solvent.

On the other hand, in the production of semiconductor devices and liquid crystal displays, interlayer insulating films and various other elements are patterned. These elements are typically exposed to high temperatures in excess of 400°C in the production process of semiconductor devices and so forth (for example, wiring deposition process by CVD). Thus, since organic materials have inadequate heat resistance, it is desirable to use inorganic materials. In particular, patterned silica-based ceramic films are known to be useful in semiconductor devices, liquid crystal displays and printed circuit boards, etc. as films having excellent heat resistance as well as excellent wear resistance, corrosion resistance, electrical resistance, transparency and so forth. For example, a method is described in Japanese Unexamined Patent Publication No. 5-88373 for forming a ceramic film pattern by coating a coating liquid containing polysilazane onto a substrate to form a coated film, and irradiating said coated film with ultraviolet light in an oxidizing atmosphere to cure the portion exposed to the ultraviolet light followed by removing the portion not exposed to the ultraviolet light. Since the above ceramic film pattern remains following curing of the portion exposed to light, it is considered to be a negative photoresist.

As described above, the processing of semiconductor devices is employing increasingly fine technology. Consequently, a type of resist is desired that is a positive resist having high resolution which also has a high degree of oxygen plasma resistance. In addition, in the case of use by allowing the patterned film to remain as an interlayer insulating film, in addition to the above requirement relating to hyperfine technology, a material is desired that is superior in terms of high heat resistance, low dielectric constant, transparency and so forth that are required for use as an interlayer insulating film.

### Disclosure of the Invention

As a result of conducting extensive research, the inventors of the present invention unexpectedly found that, when a photoacid generator is added to a polysilazane, a patterned polysilazane film is obtained by decomposing the polysilazane by irradiation with light, and removing the portion exposed to light by a following development, thereby leading to completion of the present invention.

Namely, the present invention provides the following:
(1) a photosensitive polysilazane composition containing a polysilazane and a photoacid generator as defined in claim 1; and,
(2) a method of forming a patterned polysilazane film as defined in claim 8.

The dependent claims provide preferable features of the present invention.

According to the present invention, by adding a photoacid generator to polysilazane, the polysilazane is decomposed by exposing it to light in a pattern followed by developing to obtain a patterned polysilazane film.

The patterned polysilazane film can be used directly as a photoresist. Since the photoresist according to the present invention is a positive photoresist, it has high resolution as well as greater resistance to oxygen plasma than organic material-based resists. In particular, since the polysilazane film according to the present invention has high resistance to oxygen plasma, it is extremely useful as an alternative material to silicon-containing resists in dual layer resist methods.

In addition, by allowing the patterned polysilazane film according to the present invention to stand for a long period of time or by baking the film, a patterned silica-based ceramic coating is obtained having high heat resistance, low dielectric constant and excellent transparency that are suitable for use as an interlayer insulating film.

By incorporating a sensitizing dye into the photosensitive polysilazane composition of the present invention, positive patterning can be performed using an inexpensive light source such as a high-pressure mercury lamp.

Moreover, by incorporating an oxidation catalyst into the composition of the present invention that contains a sensitizing dye, the sensitizing dye can be decomposed during baking the patterned coating, thereby obtaining a transparent, silica-based ceramic coating that is useful as the interlayer insulating film of a liquid crystal display and so forth.

In addition, by adding a pigment to the photosensitive polysilazane composition according to the present invention, a color filter or black matrix can be produced having excellent heat resistance, insulation and hardness as well as satisfactory pattern accuracy.

### Brief Description of the Drawings

Figs. 1A through 1F are schematic drawings showing the patterning step of an insulating film according to the prior art.
Figs. 2A through 2D are schematic drawings showing the patterning step of a ceramic film according to the present invention.

### Best Mode for Carrying Out the Invention

In addition to being able to use a polysilazane alone, the polysilazane used in the present invention can also be used in the form of a copolymer of a polysilazane and another polymer, or in the form of a mixture of a polysilazane and other compounds(s).

The polysilazane used consists of that which has a chain, ring or crosslinked structure, or that which simultaneously has a plurality of these structures within its molecule, and these can be used alone or as a mixture.

Although the following lists some typical examples of polysilazanes used, the polysilazane used in the present invention is not limited to these. A perhydropolysilazane is preferable in terms of hardness and fineness of the resulting film, while organopolysilazane is preferable with respect to flexibility. Selection of these polysilazanes can be suitably performed by a person with ordinary skill in the art according to the specific application.

The compound having hydrogen atoms for R¹, R² and R³ in the above general formula (I) is a perhydropolysilazane, and its production method is reported in, for example, Japanese Examined Patent Publication No. 63-16325, and by D. Seyferth et al. in Communication of Am. Cer. Soc., C-13, January 1983. Although the products obtained from these methods are mixtures of polymers having various structures, they basically contain a chain portion and ring portion in their molecule, and can represented by the following chemical formula: 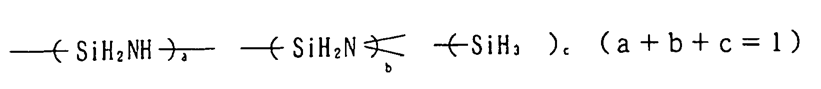 An example of the structure of a perhydropolysilazane is shown below.

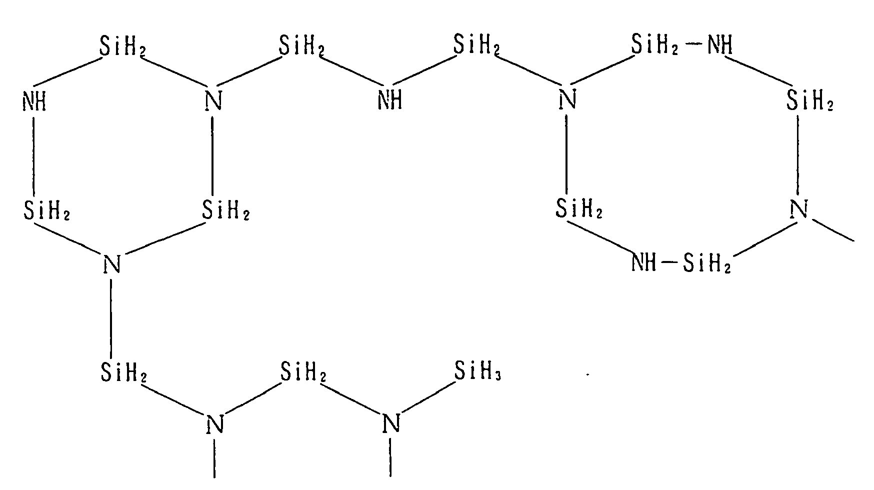

The production method of a polysilazane having hydrogen atoms for R¹ and R² and a methyl group for R³ in general formula (I) is reported by D. Seyferth et al. in Polym. Prepr., Am. Chem. Soc., Div. Polym. Chem., 25, 10 (1984). The polysilazanes obtained by this method are chain polymers and ring polymers having for their repeating unit -(SiH₂NCH₃)-, and none of them have crosslinked structures.

The production method of polyorgano(hydro)silazane having hydrogen atoms for R¹ and R³ and an organic group for R² is reported by D. Seyferth et al. in Polym. Prepr., Am. Chem. Soc., Div. Polym. Chem., 25, 10 (1984), Japanese Unexamined Patent Publication No. 61-89230 and Japanese Unexamined Patent Publication No. 62-156135. Polysilazanes obtained by these methods mainly have a ring structure with a degree of polymerization of 3-5 and have for their repeating unit -(R²SiHNH)-, or simultaneously have a chain structure and ring structure within their molecules as indicated by the chemical formula (R³SiHNH)ₓ[(R²SiH)_{1.5}N]₁₋ₓ (0.4 < x < 1).

Polysilazane having a hydrogen atom for R¹ and organic groups for R² and R³ in general formula (I), or that having organic groups for R¹ and R² and a hydrogen atom for R³ mainly has a ring structure with a degree of polymerization of 3-5 and has for its repeating unit -(R¹R²SiNR³)-.

Although the polysilazane used has a main skeleton consisting of the unit represented with the above general formula (I), the unit represented by general formula (I) may be in the form of a ring as is also clear from that previously described, and in this case, that ring portion becomes the terminal group. In the case such a ring is not formed, the terminal of the main skeleton can be a group similar to R¹, R² and R³ or a hydrogen atom.

Among polyorgano(hydro)silazanes, there are some which have a crosslinked structure within their molecules as reported by D. Seyferth et al. in Communication of Am. Cer. Soc., C-132, July 1984. An example of such a structure is shown below.

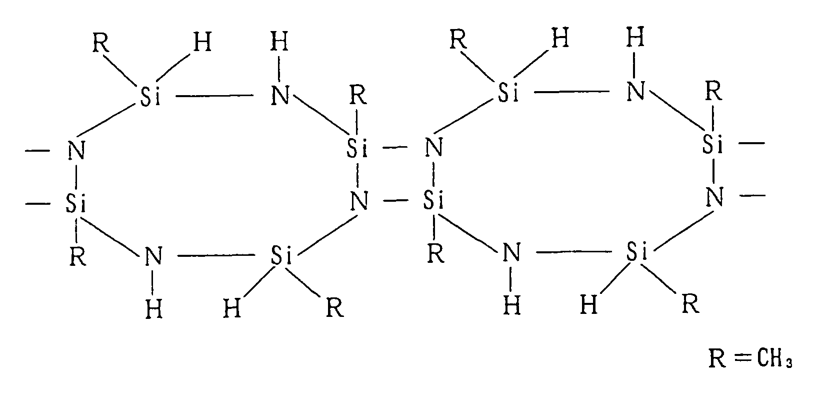

In addition, polysilazanes having a crosslinked structure that are obtained by ammonolyis of R¹SiX₃ (X: halogen) as reported in Japanese Unexamined Patent Publication No. 49-69717 (R¹Si(NH)ₓ), or polysilazanes having the following structure that are obtained by coammonolysis of R¹SiX₃ and R²₂SiX₂, can also be used as starting materials.

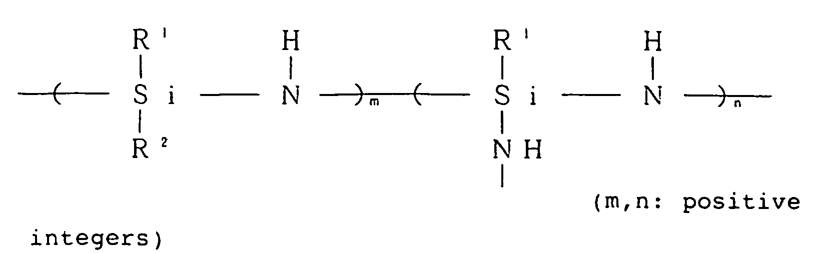

In addition, as an example of a polysilazane modification product, polymetallosilazanes containing a metal atom in the manner of, for example, the following structure (wherein, the side chain metal atom M may or may not crosslink) can also be used as starting materials.

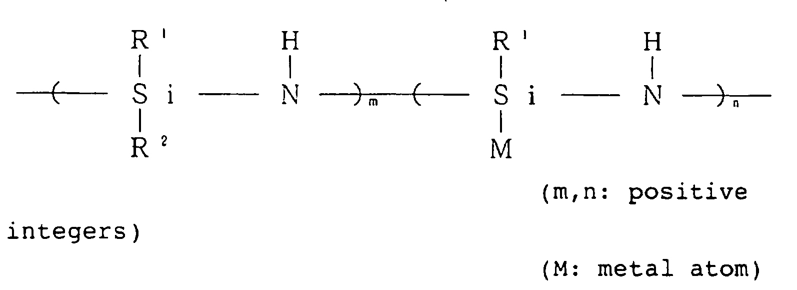

Other polysilazanes that can be used include polysiloxazanes represented with the repeating units of [(SiH₂)ₙ(NH)ₘ] and [(SiH₂)ᵣO] (wherein, n, m and r are respectively 1, 2 or 3) as reported in Japanese Unexamined Patent Publication No. 62-195024, polyborosilazanes having excellent heat resistance produced by reacting a boron compound with a polysilazane as reported in Japanese Unexamined Patent Publication No. 2-84437, polymetallosilazanes produced by reacting a polysilazane with a metal alkoxide as reported in Japanese Unexamined Patent Publication No. 63-81122, Japanese Unexamined Patent Publication No. 63-191832 and Japanese Unexamined Patent Publication No. 2-77427, inorganic silazane polymers and modified polysilazanes having increased molecular weight (as described in the first four following publications) or improved hydrolysis resistance (as described in the last two following publications) as reported in Japanese Unexamined Patent Publication No. 1-138108, Japanese Unexamined Patent Publication No. 1-138107, Japanese Unexamined Patent Publication No. 1-203429, Japanese Unexamined Patent Publication No. 1-203430, Japanese Unexamined Patent Publication No. 4-63833 and Japanese Unexamined Patent Publication No. 3-320167, copolymer polysilazanes useful for thick film formation in which an organic component is introduced into a polysilazane as reported in Japanese Unexamined Patent Publication No. 2-175726, Japanese Unexamined Patent Publication No. 5-86200, Japanese Unexamined Patent Publication No. 5-331293 and Japanese Unexamined Patent Publication No. 3-31326, and low-temperature ceramic polysilazane converting to a ceramic at lower temperatures that allows application to plastic or a metal such as aluminum to which has been imparted with have added to a catalyst compound for promoting ceramic conversion of polysilazane as reported in Japanese Unexamined Patent Publication No. 5-238827, Japanese Unexamined Patent Publication No. 6-122852, Japanese Unexamined Patent Publication No. 6-299188, Japanese Unexamined Patent Publication No. 6-306329, Japanese Unexamined Patent Publication No. 6-240208 and Japanese Unexamined Patent Publication No. 7-196986.

Polysilazanes that are particularly suitable in the present invention are polysilazanes having a number average molecular weight of 100-100,000, and preferably 300-10,000, containing a skeleton mainly represented with the following general formula (II):

- (SiR⁴(NR⁵)_{1.5})ₙ - (II)

(wherein, R⁴ and R⁵ are respectively and independently a hydrogen atom, alkyl group, alkenyl group, cycloalkyl group, aryl group, a group other than the above groups in which the portion that bonds directly to silicon or nitrogen is carbon, an alkylsilyl group, alkylamino group or alkoxy group, and n is an arbitrary integer). The most preferable polysilazane is polymethylsilazane in which R⁴ is a methyl group and R⁵ is a hydrogen atom in formula (II), or a polyphenylsilazane in which R⁴ is a phenyl group and R⁵ is a hydrogen atom in formula (II).

These polysilazanes are easily obtained by using R⁴SiCl₃ for the starting material in ammonolysis when synthesizing ordinary polysilazanes. Namely, polymethylsilazane is obtained from CH₃SiCl₃, while polyphenylsilazane is obtained from C₆H₅SiCl₃. Japanese Examined Patent Publication No. 63-16325, by the present applicant, for example, should be referred to with respect to the ammonolysis during polysilazane synthesis.

Examples of preferable polysilazane modification products in the present invention include polyorganosiloxazanes, having a number average molecular weight of 300-100,000, that contain as their main repeating unit -(RSiN₃)-, -(RSiN₂O)-, -(RSiNO₂)- and -(RSiO₃)- (wherein, R is an alkyl group, alkenyl group, cycloalkyl group, aryl group, alkylamino group or alkylsilyl group). These polyorganosiloxazanes can be produced by reacting ammonia and water with an organic halosilane represented with general formula RₙSiX₄₋ₙ (wherein, R is an alkyl group, alkenyl group, cycloalkyl group, aryl group, alkylamino group or alkylsilyl group, X is a halogen atom and n is 1 or 2). Since these polyorganosiloxazanes allow the obtaining of a baked film that exhibits a low dielectric constant even when treated at high temperatures, they are particularly useful as the precursors of interlayer insulating films. In addition, in the case of polyorganosiloxazanes, the relative dielectric constants of the baked films can be controlled by changing the oxygen content contained in the main chain, thereby offering the advantage of being able to easily provide the desired relative dielectric constant. The specification of Japanese Patent Application No. 10-528633 filed by the present applicant should be referred to for details regarding such polyorganosiloxazanes and their production method.

The photosensitive polysilazane composition according to the present invention contains a peroxide photoacid generator. A photoacid generator is transformed to an excited state either directly by exposure to light in a characteristic photosensitive wavelength region, or indirectly by exposing to light in a wavelength region in which a sensitizing dye is excited in the case of using a sensitizing dye. The Si-N bonds of polysilazane are cleaved by the photoacid generator in an excited state, and silanol (Si-OH) bonds are thought to be formed as a result of reacting with moisture in the atmosphere by going through a dangling bond state. Since silanol is soluble in the developing liquid to be described later, only the portion of the coated film of the photosensitive polysilazane composition exposed to light is dissolved, resulting in the achievement of positive patterning.

Specific examples of peroxide-based photoacid generators include 3,3',4,4'-tetra(t-butylperoxycarbonyl)benzophenone, t-butyl peroxybenzoate, methyl ethyl ketone peroxide, cyclohexanone peroxide, methylcyclohexanone peroxide, methylacetoacetate peroxide, acetylacetone peroxide, 1,1-bis(t-hexylperoxy)3,3,5-trimethylcyclohexane, 1,1-bis(t-hexylperoxy)cyclohexane, 1,1-bis(t-butylperoxy)3,3,5-trimethylcyclohexane, di-t-butylperoxy-2-methylcyclohexane, 1,1-bis(t-butylperoxy)cyclohexane, 1,1-bis(t-butylperoxy)cyclododecane, 2,2-bis(t-butylperoxy)butane, n-butyl 4,4-bis(t-butylperoxy)valerate, 2,2-bis(4,4-di-t-butylperoxycyclohexyl)propane, p-menthane hydroperoxide, diisopropylbenzene hydroperoxide, 1,1,3,3-tetramethylbutyl hydroperoxide, cumene hydroperoxide, t-hexyl hydroperoxide, t-butyl hydroperoxide, α,α'-bis(t-butylperoxy)diisopropylbenzene, dicumyl peroxide, 2,5-dimethyl-2,5-bis(t-butylperoxy)hexane, t-butylcumylperoxide, di-t-butylperoxide, 2,5-dimethyl-2,5-bis(t-butylperoxy)hexyne-3, isobutyl peroxide, 3,5,5-trimethylhexanoyl peroxide, octanoyl peroxide, lauroyl peroxide, stearoyl peroxide, succinyl peroxide, m-toluoylbenzoyl peroxide, benzoyl peroxide, di-n-propyl peroxydicarbonate, diisopropyl peroxydicarbonate, bis(4-t-butylcyclohexyl) peroxydicarbonate, di-2-ethoxyethyl peroxydicarbonate, di-2-ethylhexyl peroxydicarbonate, di-3-methoxybutyl peroxydicarbonate, di(3-methyl-3-methoxybutyl) peroxydicarbonate, α,α'-bis(neodecanoylperoxy)diisopropylbenzene, cumyl peroxyneodecanoate, 1,1,3,3-tetramethylbutyl peroxyneodecanoate, 1-cyclohexyl-1-methylethyl peroxyneodecanoate, t-hexyl peroxyneodecanoate, t-butyl peroxyneodecanoate, t-hexyl peroxypivalate, t-butyl peroxypivalate, 1,1,3,3-tetramethylbutyl peroxy-2-ethylhexanoate, 2,5-dimethyl-2,5-bis(2-ethylhexanoylperoxy)hexane, 1-cyclohexyl-1-methylethyl peroxy-2-ethylhexanoate, t-hexyl peroxy 2-ethylhexanoate, t-butyl peroxy 2-ethylhexanoate, t-butyl peroxyisobutyrate, t-hexyl peroxyisopropylmonocarbonate, t-butyl peroxymaleate, t-butyl peroxy 3,5,5-trimethyl hexanoate, t-butyl peroxylaurate, 2,5-dimethyl-2,5-(m-toluoylperoxy)hexane, t-butyl peroxyisopropylmonocarbonate, t-butyl peroxy 2-ethylhexylmonocarbonate, t-hexyl peroxybenzoate, 2,5-dimethyl-2,5-bis(benzoylperoxy)hexane, t-butyl peroxyacetate, t-butyl peroxy-m-toluoylbenzoate, bis(t-butylperoxy)isophthalate, t-butyl peroxyallylmonocarbonate, t-butyl trimethylsilylperoxide, 2,3-dimethyl-2,3-diphenylbutane, 1,3-di(t-butylperoxycarbonyl)benzene and the like.

The photosensitive polysilazane composition according to the present invention typically contains 0.05-50 wt% of the above photoacid generator relative to the weight of polysilazane according to the type of photoacid generator and application. If the content of photoacid generator is less than 0.05 wt%, the decomposition reaction rate becomes extremely slow, and conversely, if the content of photoacid generator exceeds 50 wt%, it becomes difficult to obtain a fine film that is a characteristic inherent to polysilazane. The photoacid generator is preferably contained at 0.1-20 wt%, and more preferably at 1-20 wt%, relative to the weight of polysilazane.

Preparation of the photosensitive polysilazane composition according to the present invention is performed by adding the above photoacid generator to polysilazane. The photoacid generator is preferably mixed uniformly and, in order to accomplish this, the polysilazane and photoacid generator are preferably mixed while adequately stirring, or they are mixed after being respectively dissolved in a solvent to be described later and diluted. In the case the photoacid generator is a solid during mixing in particular, it is preferable to mix after first dissolving in a solvent.

There are no particular restrictions on the temperature and pressure during addition, and addition can be performed at room temperature and under atmospheric pressure. However, during the time from addition of photoacid generator to the development step to be described later, work should be performed in an atmosphere that does not contain the photosensitive wavelength of the optically acid-generating agent used, and preferably in a dark location, so as to prevent excitation of the photoacid generator.

There are cases in which it is advantageous to mix a sensitizing dye into the photosensitive polysilazane composition according to the present invention. Depending on the particular photoacid generator, as in the manner of, for example, 3,3',4,4'-tetra(t-butylperoxycarbonyl)benzophenone, the wavelength at which that substance itself is excited is shorter than about 330 nm. In the case of performing light exposure using an excimer laser such as a KrF-based (248 nm) or ArF-based (193 nm) laser, since the photoacid generator is excited directly, there is no need to use a sensitizing dye. However, in the case of using an inexpensive light source such as a high-pressure mercury lamp (360-430 nm), the photoacid generator can be excited indirectly by combining a sensitizing dye that is excited in that wavelength region. In this manner, the photosensitive polysilazane composition of the present invention can be patterned using an inexpensive light source by adding a sensitizing dye.

Examples of the sensitizing dye that can be used in the photosensitive polysilazane composition of the present invention include coumarin, ketocoumarin and their derivatives, thiopyrylium salts and so forth, specific examples of which include p-bis(o-methylstyryl)benzene, 7-dimethylamino-4-methylquinolone-2, 7-amino-4-methylcoumarin, 4,6-dimethyl-7-ethylaminocoumarin, 2-(p-dimethylaminostyryl)-pyridylmethyl iodide, 7-diethylaminocoumarin, 7-diethylamino-4-methylcoumarin, 2,3,5,6-1H,4H-tetrahydro-8-methylquinolidino-<9,9a,1-gh>coumarin, 7-diethylamino-4-trifluoromethylcoumarin, 7-dimethylamino-4-trifluoromethylcoumarin, 7-amino-4-trifluoromethylcoumarin, 2,3,5,6-1H,4H-tetrahydroquinolidino-<9,9a,1-gh>coumarin, 7-ethylamino-6-methyl-4-trifluoromethylcoumarin, 7-ethylamino-4-trifluoromethylcoumarin, 2,3,5,6-1H,4H-tetrahydro-9-carboethoxyquinolidino-<9,9a,1-gh>coumarin, 3-(2'-N-methylbenzimidazolyl)-7-N,N-diethylaminocoumarin, N-methyl-4-trifluoromethylpiperidino-<3,2-g>coumarin, 2-(p-dimethylaminostyryl)-benzothiazolylethyl iodide, 3-(2'-benzimidazolyl)-7-N,N-diethylaminocoumarin, 3-(2'-benzothioazolyl)-7-N,N-diethylaminocoumarin, and the pyrylium salts and thiopyrylium salts represented by the formula indicated below.

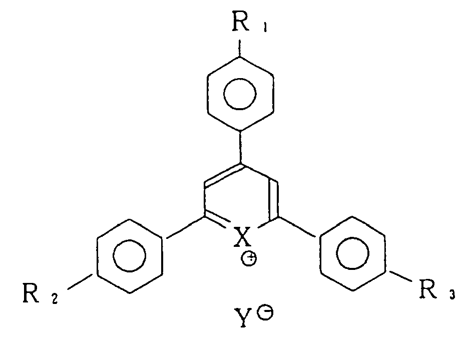

| X | R₁ | R₂ | R₃ | Y |
|---|---|---|---|---|
| | | | | |
| S | OC₄H₉ | H | H | BF₄ |
| S | OC₄H₉ | H | H | BF₄ |
| S | OC₄H₉ | OCH, | OCH, | BF₄ |
| S | H | OCH, | OCH, | BF₄ |
| S | N(CH₃)₂ | H | H | ClO₂ |
| O | OC₄H₉ | H | H | SbF₆ |

Moreover, the following lists different specific examples of sensitizing dyes.

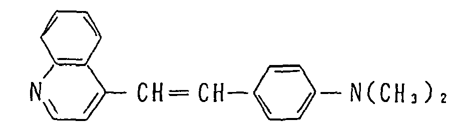

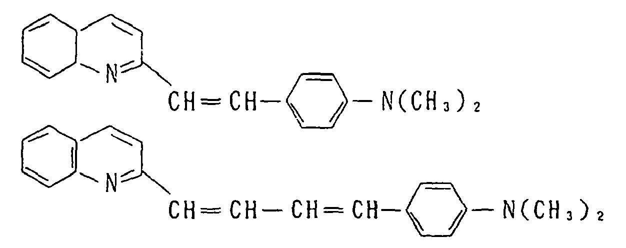

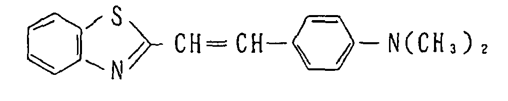

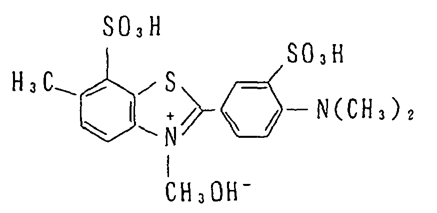

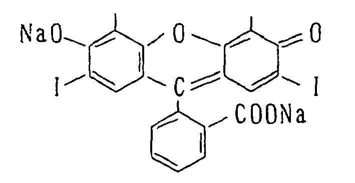

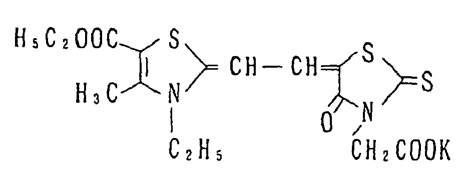

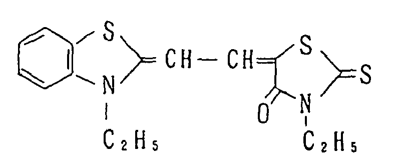

Particularly preferable sensitizing dyes are 7-diethylamino-4-methylcoumarin and 7-diethylamino-4-trifluoromethylcoumarin.

In the case of combining a sensitizing dye, the above sensitizing dye should be typically contained at 0.05-50 wt%, and preferably at 1-20 wt%, relative to the weight of polysilazane in the photosensitive polysilazane composition according to the present invention.

In the case of mixing a sensitizing dye into the photosensitive polysilazane composition according to the present invention, the resulting film may be colored. In the case of using said composition as a photoresist, since said resist is removed following completion of the desired patterning, coloring of the resist hardly presents any problems. However, in the case of preparing an interlayer insulating film that is patterned using the composition of the present invention and so forth, when this is used without removing the film containing a sensitizing dye after patterning, there are cases in which it is necessary that the film after baking be transparent with respect to visible light. In such cases as well, the photoacid generator contained in the composition of the present invention is able to decompose the sensitizing dye during film baking to make the film transparent. Moreover, although not directly involved in the photoreaction, by separately adding an oxidation catalyst that decomposes the sensitizing dye during film baking to the composition of the present invention, an even more transparent film can be obtained. Examples of such oxidation catalysts include organic compounds and fine particles, etc. of metals, such as palladium propionate, palladium acetate, platinum acetylacetonate, platinum ethylacetonate, palladium fine particles and platinum fine particles.

In the case of adding an oxidation catalyst, typically 0.05-10 wt%, and preferably 0.1-5 wt%, should be contained relative to the weight of polysilazane in the photosensitive polysilazane composition according to the present invention. In addition, the addition of this oxidation catalyst not only decomposes and decolorizes any unnecessary dye, but also promotes the ceramic conversion of a polysilazane.

As a different mode of the present invention, a polysilazane composition can be obtained that is suitable for the production of color filters and black matrices having excellent heat resistance, insulation and hardness as well as satisfactory pattern accuracy by adding a pigment to the above photosensitive polysilazane composition. In color filters and black matrices obtained from the photosensitive polysilazane composition containing a pigment according to the present invention, since the pigment is dispersed in silica-based ceramics, oxygen is blocked out resulting in excellent heat resistance (oxidation resistance at high temperatures), and even if the pigment itself is electrically conductive, an insulator is obtained in the form of a color filter or black matrix. In addition, since silica-based ceramic films have a higher degree of hardness than typical acrylic, polyimide or other organic films, the surface workability (film deposition, wiring and bonding work) of the resulting color filter or black matrix is satisfactory, making it possible to improve the yield. Moreover, the amount of gas generated by the ceramic film during heating is extremely low in comparison with the amount of gas generated from typical organic films.

Examples of pigments that can be added to the photosensitive polysilazane composition of the present invention include graphite, carbon black, titanium black, iron oxide, copper-chromium black, copper-iron-manganese black and cobalt-iron-chromium black. The amount of pigment added is typically 0.05-1000 wt%, and preferably 10-500 wt%, relative to the weight of polysilazane.

In the case of using a pigment, preparation of the photosensitive polysilazane composition containing the pigment according to the present invention is performed by adding the above photoacid generator and/or the above sensitizing dye and/or the above oxidation catalyst along with the pigment to polysilazane. Although there is no particular problem with the order of addition, it is preferable that both be mixed uniformly. In order to accomplish this, it is preferable that they be mixed with adequate stirring during addition, or that they be mixed after dissolving or dispersing photoacid generator and/or the above sensitizing dye and/or the above oxidation catalyst in a solvent to be described later and diluting.

In the case of using a solvent, it is preferable to use an aromatic compound such as benzene, toluene, xylene, ethylbenzene, diethylbenzene, trimethylbenzene or triethylbenzene; cyclohexane; cyclohexene; decahydronaphthalene; dipentene; a saturated hydrocarbon compound such as n-pentane, i-pentane, n-hexane, i-hexane, n-heptane, i-heptane, n-octane, i-octane, n-nonane, i-nonane, n-decane or i-decane; ethylcyclohexane; methylcyclohexane; p-menthane; ethers such as dipropyl ether and dibutyl ether; ketones such as methyl isobutyl ketone (MIBK); or esters such as butyl acetate, cyclohexyl acetate and butyl stearate. In the case of using these solvents, two or more types of solvents may be mixed to adjust the solubility of polysilazane or adjust the evaporation rate of solvent.

The amount of solvent used (ratio) is selected so as to improve workability according to the coating method to be employed later. Since this varies according to the average molecular weight, molecular weight distribution and structure of the polysilazane used, they can be mixed freely as is appropriate. However, it is preferable that the polysilazane concentration be 0.1-50 wt%, and more preferably 0.1-40 wt%, in consideration of the stability and the production efficiency of the polysilazane.

In addition, a suitable filler and/or extender can be added to the photosensitive polysilazane composition according to the present invention as necessary. Examples of fillers include fine particles of oxide-based inorganic substances such as silica, alumina, zirconia or mica, or non-oxide-based inorganic substances such as silicon carbide and silicon nitride. A powder of metal such as alminum, zinc and copper may also be added to the composition, depending on applications. These fillers may be in the form of needles (including whiskers), particles, scales or various other forms, and they may be used alone or as a mixture of two or more types. In addition, the particle size of these fillers is preferably smaller than the film thickness that can be applied once. In addition, the amount of filler added is within the range of 0.05-10 parts by weight, and particularly preferably 0.2-3 parts by weight, relative to 1 part by weight of polysilazane.

Various pigments, leveling agents, antifoaming agents, antistatic agents, UV absorbers, pH adjusters, dispersants, surface modifiers, plasticizers, drying accelerators and antirunning agents may be added as necessary to the photosensitive polysilazane composition of the present invention.

According to the present invention, a method is provided for forming a patterned silica-based ceramic film using the above photosensitive polysilazane composition. Namely, the method of the present invention comprises: a step in which a coated film is formed of a photosensitive polysilazane composition containing a polysilazane and a photoacid generator, a step in which said coated film is exposed to light in a pattern, and a step in which the exposed portion of said coated film is dissolved off.

An ordinary coating method, namely immersion, roll coating, bar coating, brush coating, spray coating, flow coating or spin coating and so forth is employed for forming the coated film of the photosensitive polysilazane composition according to the present invention, and coating can be performed on a suitable substrate such as a silicon substrate or glass substrate. In addition, if the base material is a film, coating can also be performed by gravure coating. A drying step for the coated film can also be provided separately as desired.

The coated film can be given a desired film thickness by coating once or repeatedly coating two or more times as necessary. Although the desired film thickness varies according to the particular application, in the case of a photoresist, for example, a general indicator of film thickness is 0.05-2 µm, that in the case of an interlayer insulating film is 0.5-4 µm, and that in the case of a color filter or black matrix is 0.3-3 µm.

After forming a coated film of the photosensitive polysilazane composition of the present invention, in order to dry said coated film and reduce the amount of gas discharged later, it is preferable to pre-bake (heat-treat) said coated film. The pre-baking step can be carried out at a temperature of typically 40-200°C, and preferably 60-120°C, for 10-180 seconds, and preferably 30-90 seconds, in the case of using a hot plate, or for 1-30 minutes, and preferably 5-15 minutes, in the case of using a clean oven.

After forming a coated film of the photosensitive polysilazane composition of the present invention, and pre-baking as necessary, said coated film is exposed to light in a pattern. Examples of light sources that can be used include a high-pressure mercury lamp, low-pressure mercury lamp, metal halide lamp and excimer laser. The light used for exposure is typically light having a wavelength of 360-430 nm (high-pressure mercury lamp) with the exception of applications involving hyperfine processing as in the manner of semiconductors. In the case of liquid crystal displays in particular, light having a wavelength of 430 nm is frequently used. In such cases, it is advantageous to combine a sensitizing dye with the photosensitive polysilazane composition of the present invention as was previously described.

Although varying according to the light source and expected film thickness, the energy of the radiated light is typically 5-4000 mJ/cm², and preferably 10-2000 mJ/cm². If this energy is lower than 5 mJ/cm², the polysilazane is not adequately decomposed, and conversely, if this energy exceeds 4000 mJ/cm², exposure becomes excessive, possibly inviting the occurrence of halation.

In order to expose to light in a pattern, an ordinary photomask may be used, and such photomasks are commonly known to persons with ordinary skill in the art.

Although the environment during exposure may typically be an ambient atmosphere (air) or nitrogen, the atmosphere may also be enriched with oxygen to promote decomposition of polysilazane.

In the exposed portion of the photosensitive polysilazane composition that has been exposed to light in a pattern, the Si-N bond of the polysilazane is cleaved and, as a result of reacting with moisture in the atmosphere by going through a dangling bond state, a silanol (Si-OH) bond is formed and the polysilazane decomposes. In order to promote the formation of this silanol bond, water, and preferably pure water, may be brought in contact with the polysilazane composition following exposure. The exposed portion of the photosensitive polysilazane composition is removed by developing the coated film after exposure, and a pattern (positive type) is formed as a result of the non-exposed portion remaining on the substrate. Since the residual polysilazane hardly swells at all in the developing liquid to be described later, the pattern of the radiated light and the pattern of the polysilazane that is dissolved away are nearly completely identical, resulting in a satisfactory pattern accuracy (resolution).

An alkaline aqueous solution can be used for the developing liquid during removal, namely development, of the exposed portion of the photosensitive polysilazane composition. Examples of such alkaline aqueous solutions include aqueous solutions of tetramethylammonium hydroxide (TMAH), sodium silicate, sodium hydroxide and potassium hydroxide. In the development in the present invention, it is convenient to use a roughly 2% aqueous solution of TMAH, which is the industry standard alkaline developing liquid.

Although varying according to film thickness and solvent, the time required for developing is typically 0.1-5 minutes, and preferably 0.5-3 minutes. In addition, the developing treatment temperature is typically 20-50°C, and preferably 20-30°C.

As a result of developing, the exposed portion of the photosensitive polysilazane composition is removed and patterning is completed. The patterned polysilazane film can be used as is as a photoresist having strong chemical resistance. Since the photoresist according to the present invention is of the positive type, it has high resolution and is highly resistant to dry etching. In particular, since the photoresist according to the present invention is highly resistant to oxygen plasma, it is extremely useful as an alternative material to silicon-containing resists in dual layer resist methods.

After etching a lower layer or substrate by using the photoresist according to the present invention as a protective film, the photoresist that is no longer required is removed. The polysilazane may be dissolved off using the above polysilazane solvent in order to remove the photoresist of the present invention.

In the case of using the patterned polysilazane film according to the present invention by allowing it to remain in the form of an interlayer insulating film and so forth, it may be converted to a silica-based ceramic coating having high heat resistance, low dielectric constant and excellent transparency, and so forth, by allowing it to stand for a long period of time or by baking it. In the case of allowing a polysilazane film to stand after developing, it may typically be allowed to stand for a long time, for example one day or more, in an ambient atmosphere (in air at room temperature). In addition, in the case of baking, although varying according to the type of polysilazane used as well as the heat resistance of the substrate, electronic components and so forth, the baking temperature is typically 50-1000°C, preferably 100-1000°C and more preferably 150-450°C. Baking time is typically 5 minutes or more, and preferably 10 minutes or more. Although the baking atmosphere may typically be an ambient atmosphere (air), an atmosphere rich in oxygen and/or water vapor partial pressure may be used to promote the oxidation of polysilazane.

A silica-based ceramic coating obtained in this manner is able to demonstrate a dielectric constant of 5 or less, and depending on the particular case, 3.3 or less, as well as a resistivity of 10¹³Ωcm or more.

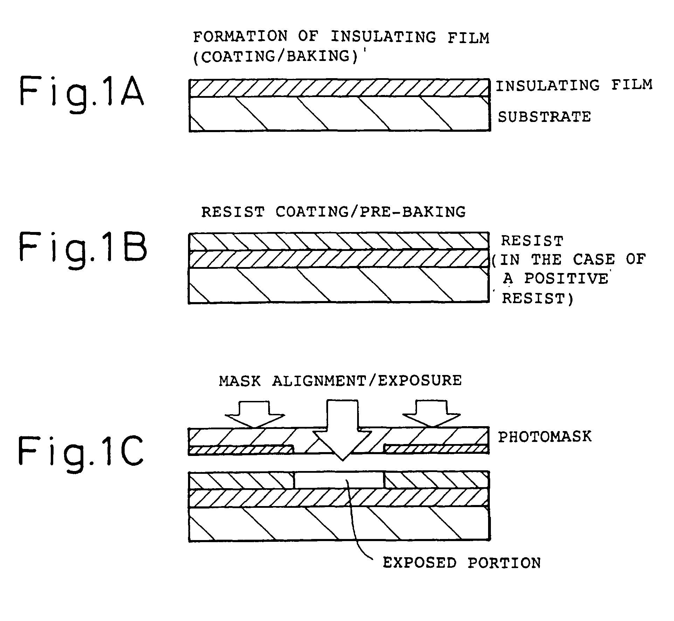

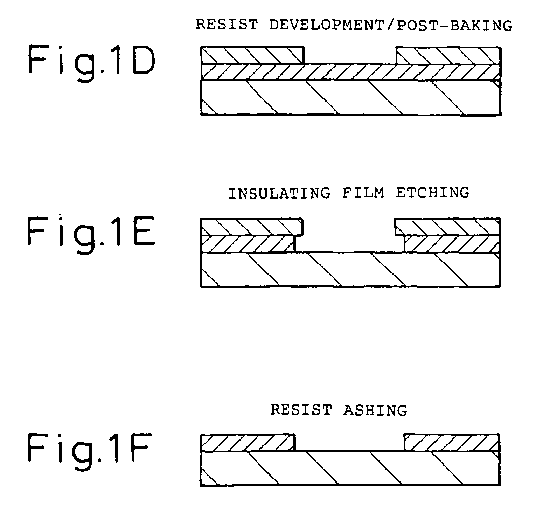

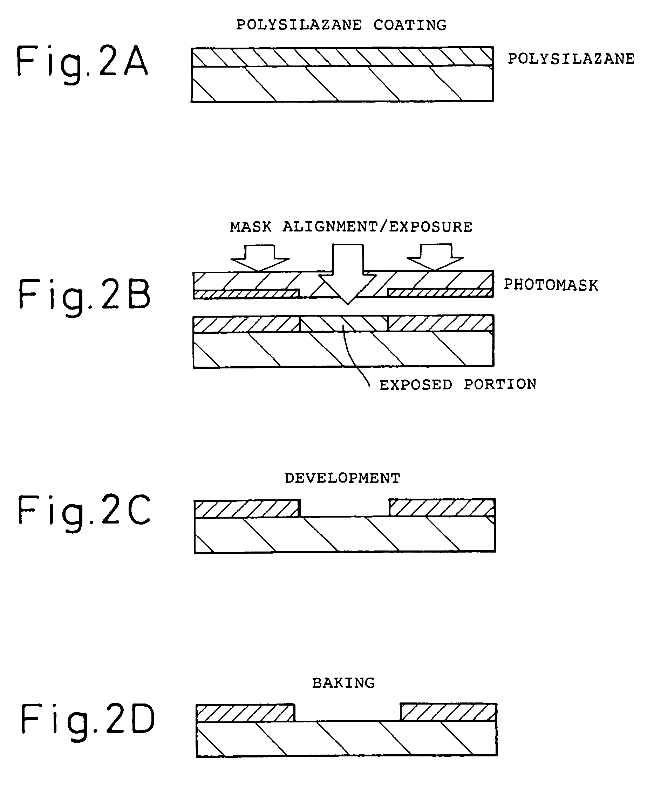

According to the present invention, since polysilazane can be patterned directly in a photolithography step, a conventional photoresist is no longer required in the patterning step of an insulating film or other ceramic film, thereby resulting in simplification of the process. Namely, as shown in Figs. 1A through 1F, although a coating/baking step for forming an insulating film on a substrate (1A), a coating/pre-baking step for forming a resist on an insulating film (1B), a mask alignment/exposure step in which exposure is performed in a pattern through a photomask (1C), a resist developing/post-baking step (1D), an insulating film etching step (1E) and a resist ashing step (1F) are required in the method of the prior art, according to the present invention, as shown in Figs. 2A through 2D, only a step for coating polysilazane (2A), a mask alignment/exposure step for exposing in a pattern through a photomask (2B), a developing step (2C) and a baking step (2D) are required, thereby making it possible to eliminate the resist coating/pre-baking step and resist ashing step, making this invention extremely useful.

The following provides an additional explanation of the present invention through its examples.

### Example 1

15 wt% of the photoacid generator t-butylperoxybenzoate was added to a 20% butyl acetate solution of polyphenylsilazane relative to the amount of polyphenylsilazane.

This solution was spin-coated (rotating speed: 1500 rpm) onto a silicon wafer to form a coated film. After hot air drying this coated film for 20 minutes at 70°C, it was exposed to light at 100 mJ/cm² of a KrF excimer laser having a wavelength of 248 nm through a photomask having a prescribed pattern.

Following exposure, the coated film was immersed for 2 minutes in pure water. When the coated film was subsequently immersed for 3 minutes in a 2% aqueous solution of tetramethylammonium hydroxide (TMAH) (developing liquid), the exposed portion of the coated film dissolved and a pattern originating in the photomask was formed. The patterning accuracy was 0.75 µm or better.

Following patterning, the coated film was heat-treated for 10 minutes at 170°C in an air atmosphere using a hot plate in order to dry the coated film and reduce the amount of subsequent degassing. The film thickness of the coated film after heat treatment was 0.45 µm.

The silicon wafer having this patterned coated film was placed in an asher (oxygen plasma ashing system), high-frequency power of 500 W and 13.56 MHz was applied at 500 millitorr (about 66.6 Pa), and the wafer was exposed to oxygen plasma for 10 minutes. When the silicon wafer was subsequently taken out of the asher and the film thickness of the coated film was measured, it was found to be 0.43 µm, and demonstrated a residual ratio of about 96%. This result indicates that photosensitive polyphenylsilazane is useful as a photoresist.

### Example 2

5 wt% of the photoacid generator 3,3',4,4'-tetra(t-butylperoxycarbonyl)benzophenone was added to a 15% cyclohexyl acetate solution of polymethylsilazane relative to the amount of polymethylsilazane.

This solution was spin-coated (rotating speed: 1500 rpm) onto a silicon wafer to form a coated film. After hot air drying this coated film for 20 minutes at 70°C, it was exposed to light at 100 mJ/cm² of a KrF excimer laser having a wavelength of 248 nm through a photomask having a prescribed pattern.

Following exposure, the coated film was immersed for 2 minutes in pure water. When the coated film was subsequently immersed for 3 minutes in a 2% aqueous solution of TMAH (developing liquid), the exposed portion of the coated film dissolved and a pattern originating in the photomask was formed. The patterning accuracy was 0.75 µm or more.

Following patterning, the coated film was heat-treated for 10 minutes at 170°C in an air atmosphere using a hot plate in order to dry the coated film and reduce the amount of subsequent degassing. The film thickness of the coated film after heat treatment was 0.51 µm.

The silicon wafer having this patterned coated film was placed in an asher, high-frequency power of 500 W and 13.56 MHz was brought in at 500 millitorr (about 66.6 Pa), and the wafer was exposed to oxygen plasma for 10 minutes. When the silicon wafer was subsequently taken out of the asher and the film thickness of the coated film was measured, it was found to be 0.48 µm, and demonstrated a residual ratio of about 94%. This result indicates that photosensitive polymethylsilazane is useful as a photoresist.

### Comparative Example

An acrylic positive resist (TOK: OFPR-800) was coated onto a silicon wafer to form a coated film of about 2 µm. This film was heat-treated for 20 minutes at 140°C in an air atmosphere using a hot plate.

When this resist film was exposed to oxygen plasma in an asher in the same manner as Example 1, the entire film was lost.

### Example 3

5 wt% of the photoacid generator 3,3',4,4'-tetra(t-butylperoxycarbonyl)benzophenone was added to a 15% cyclohexyl acetate solution of polymethylsilazane relative to the amount of polymethylsilazane, followed by addition of 10 wt% of the sensitizing dye 7-diethylamino-4-trifluoroethylcoumarin relative to the amount of polymethylsilazane.

This solution was spin-coated (rotating speed: 1500 rpm) onto a silicon wafer to form a coated film. After hot air drying this coated film for 10 minutes at 50°C, it was exposed to light at 50 mJ/cm² of a high-pressure mercury lamp through a photomask having a prescribed pattern.

Following exposure, the coated film was immersed for 2 minutes in pure water. When the coated film was subsequently immersed for 3 minutes in a 2% aqueous solution of TMAH (developing liquid), the exposed portion of the coated film dissolved and a pattern originating in the photomask was formed.

Following patterning, the coated film was pre-baked for 3 minutes at 150°C using a hot plate, and baked for 1 hour in a clean oven at 300°C to convert it into a ceramic. The film thickness of the baked film was 0.50 µm.

This baked film exhibited a resistivity of 5 x 10¹⁴ and a dielectric constant of 3.0. In addition, the transmittance of the baked film was 99.9% at 500 nm, and 99.1% at 400 nm. These results indicate that the photosensitive polymethylsilazane according to the present invention is also useful as a patternable interlayer insulating film having high insulation, low dielectric constant and excellent transparency.

### Example 4

10 wt% of the photoacid generator α,α'-bis(t-butylperoxy)diisopropylbenzene was added to a 40% dibutyl ether solution of polyphenylsilazane relative to the amount of polybutylsilazane, followed by the addition of 5 wt% of the thiopyrylium salt sensitizing dye having the following formula relative to the amount of polyphenylsilazane.

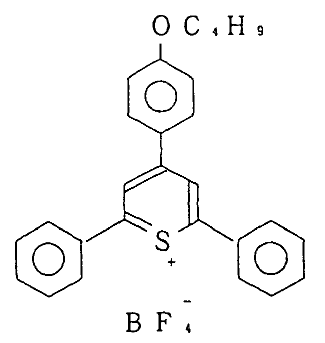

This solution was spin-coated (rotating speed: 1500 rpm) onto a silicon wafer to form a coated film. After hot air drying this coated film for 20 minutes at 70°C, it was exposed to light at 50 mJ/cm² of a high-pressure mercury lamp through a photomask having a prescribed pattern.

Following exposure, the coated film was immersed for 2 minutes in pure water. When the coated film was subsequently immersed for 3 minutes in a 2% aqueous solution of TMAH (developing liquid), the exposed portion of the coated film dissolved and a pattern originating in the photomask was formed.

Following patterning, the coated film was pre-baked for 3 minutes at 150°C using a hot plate, and baked for 1 hour in a baking oven at 400°C to convert it into a ceramic. The film thickness of the baked film was 2.5 µm.

This baked film exhibited resistivity of 7 x 10¹⁴ and a dielectric constant of 2.9. In addition, the transmittance of the baked film was 99% at 500 nm, and 96% at 400 nm. These results indicate that the photosensitive polyphenylsilazane according to the present invention is also useful as a patternable interlayer insulating film having high insulation, low dielectric constant and excellent transparency.

### Example 5

10 wt% of the photoacid generator α,α'-bis(t-butylperoxy)diisopropylbenzene was added to a 15% dibutyl ether solution of polyphenylsiloxazane (oxygen content of 10 atomic % relative to Si) relative to the amount of polyphenylsiloxazane, followed by the addition of 5 wt% of thiopyrylium salt sensitizing dye.

This solution was spin-coated (rotating speed: 1500 rpm) onto a silicon wafer to form a coated film. After hot air drying this coated film for 3 minutes at 80°C, it was exposed to light at 50 mJ/cm² of a high-pressure mercury lamp through a photomask having a prescribed pattern.

Following exposure, the coated film was immersed for 2 minutes in pure water. When the coated film was subsequently immersed for 3 minutes in a 2% aqueous solution of TMAH (developing liquid), the exposed portion of the coated film dissolved and a pattern originating in the photomask was formed.

Following patterning, the coated film was pre-baked for 5 minutes at 170°C using a hot plate, and baked for 1 hour in a baking oven at 400°C to convert the coated film into a ceramic. The film thickness of the baked film was 0.35 µm.

This baked film exhibited a resistivity of 5 x 10¹⁴ and a dielectric constant of 2.7. These results indicate that the photosensitive polyphenylsiloxazane according to the present invention is also useful as a patternable interlayer insulating film having high insulation and low dielectric constant.

### Example 6 which does not fall under the claimed invention

5 wt% of esters (mixture of mono-, di- and triesters) of 2,3,4-trihydroxybenzophenone and 6-diazo-5,6-dihydro-5-oxo-naphthalene-1-sulfonic acid was added to a 20% PGMEA (propylene glycol monomethyl ether acetate) solution of polymethylsilazane relative to the amount of polymethylsilazane.

This solution was spin-coated (3000 rpm) onto a silicon wafer to form a coated film. After drying this coated film for 1 minute at 90°C over a hot plate, it was exposed to light at 40 mJ/cm² of a high-pressure mercury lamp through a photomask having a prescribed pattern.

Following exposure, the coated film was allowed to stand for 10 minutes in air. When the coated film was subsequently immersed for 1 minute in a 2.38% aqueous solution of TMAH, the exposed portion dissolved and a pattern originating in the photomask was formed.

When this film was baked for 30 minutes in a clean oven at 400°C followed by SEM observation, patterning was confirmed to have a minimum line width of 0.5 µm.

### Industrial Application

According to the present invention, by adding an optically acid-generating agent to polysilazane and exposing to light in a pattern, the polysilazane dissolves, allowing a patterned polysilazane film to be obtained following development.

The patterned polysilazane film can be used as it is as a photoresist. Since the photoresist according to the present invention is of the positive type, it has high resolution and higher resistance to oxygen plasma than organic material-based resists. In particular, since the polysilazane film according to the present invention has high resistance to oxygen plasma, it is extremely useful as an alternative material to silicon-containing resists in dual layer resist methods.

In addition, by allowing the patterned polysilazane film according to the present invention to stand for a long period of time, or by baking it, a silica-based ceramic coating can be obtained that has preferable high heat resistance, low dielectric constant and excellent transparency and so forth as an interlayer insulating film.

Positive patterning can be performed using an inexpensive light source such as a high-pressure mercury lamp by adding a sensitizing dye to the photosensitive polysilazane composition of the present invention.

Moreover, by adding an oxidation catalyst to the composition of the present invention that contains a sensitizing dye, said sensitizing dye can be decomposed during coating baking after patterning, thereby allowing a transparent, silica-based ceramic coating, that is useful as the interlayer insulating film of a liquid crystal display and so forth to be obtained.

In addition, by adding a pigment to the photosensitive polysilazane composition according to the present invention, a color filter or black matrix can be produced having excellent heat resistance, insulation and hardness as well as satisfactory pattern accuracy.

## Claims

1. A photosensitive polysilazane composition comprising a polysilazane and a photoacid generator for forming a patterned insulating film by ceramic conversion; wherein, said polysilazane is a polysilazane, or its modification product having a number average molecular weight of 100 to 50,000, that mainly contains the skeleton represented with the following general formula (I) or a polysilazane having a number average molecular weight of 100 to 100,000 that mainly contains the skeleton represented with the following general formula (II), and said photoacid generator is a peroxide, 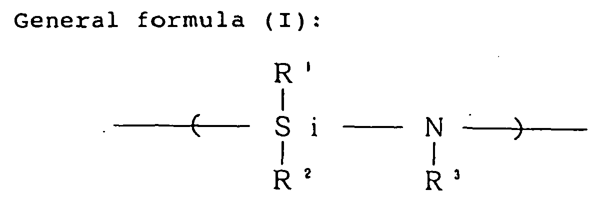 wherein, R¹, R² and R³ respectively and independently represent a hydrogen atom, an alkyl group, an alkenyl group, a cycloalkyl group, an aryl group, a group other than these groups in which the portion bonded directly to silicon or nitrogen is carbon, an alkylsilyl group, an alkylamino group or an alkoxy group;
General formula (II): - (SiR⁴(NR⁵)_{1.5})ₙ -
wherein, R⁴ and R⁵ respectively and independently represent a hydrogen atom, an alkyl group, an alkenyl group, a cycloalkyl group, an aryl group, a group other than these groups in which the portion bonded directly to silicon or nitrogen is carbon, an alkylsilyl group, an alkylamino group or an alkoxy group, and n is an arbitrary integer.

2. The photosensitive polysilazane composition according to claim 1 wherein said polysilazane modification product is polyorganosiloxazane having a number average molecular weight of 300 to 100,000 that contains as its main repeating unit, -(RSiN₃)-, -(RSiN₂O)-, -(RSiNO₂)- and -(RSiO₃)- (wherein, R is an alkyl group, alkenyl group, cycloalkyl group, aryl group, alkylamino group or alkylsilyl group).

3. The photosensitive polysilazane composition according to claim 1 or 2 wherein, said peroxide is t-butyl peroxybenzoate, 3,3',4,4'-tetra(t-butylperoxycarbonyl)benzophenone or α,α'-bis(t-butylperoxy)diisopropylbenzene.

4. The photosensitive polysilazane composition according to any one of claims 1 through 3 that further contains a sensitizing dye.

5. The photosensitive polysilazane composition according to claim 4 wherein, said sensitizing dye is selected from coumarin, ketocoumarin and their derivatives and thiopyrylium salts.

6. The photosensitive polysilazane composition according to either of claims 4 or 5 wherein that further contains an oxidation catalyst.

7. The photosensitive polysilazane composition according to claim 6 wherein, said oxidation catalyst is palladium propionate.

8. A method of forming a patterned polysilazane film comprising: a step in which a coated film is formed of a photosensitive polysilazane composition comprising a polysilazane and a photoacid generator according to any of claims 1 to 7, a step in which said coated film is exposed to light in a pattern, and a step in which the exposed portion of said coated film is dissolved off.

9. The method according to claim 8 wherein, said dissolving off step is performed using a weakly alkaline aqueous solution.

10. A method of forming a patterned insulating film containing a step in which a patterned polysilazane film formed by the method according to claim 8 is converted to a silica-based ceramic coating by allowing the film to stand in an ambient atmosphere or by baking the film.

## Patentansprüche

1. Lichtempfindliche Polysilazan-Zusammensetzung umfassend ein Polysilazan und ein Photosäure-Erzeuger zur Ausbildung einer gemusterten Isolierschicht durch keramische Umsetzung; worin das Polysilazan ein Polysilazan, oder sein Modifizierungsprodukt mit einem Zahlenmittel des Molekulargewichts von 100 bis 50 000, das im Wesentlichen das Rückrad, das mit der folgenden allgemeinen Formel (I) dargestellt ist, enthält, oder ein Polysilazan mit einem Zahlenmittel des Molekulargewichts von 100 bis 100 000, das im Wesentlichen das Skelett, das mit der folgenden allgemeinen Formel (II) dargestellt ist, enthält, ist, und besagter Photosäure-Erzeuger ein Peroxid ist: 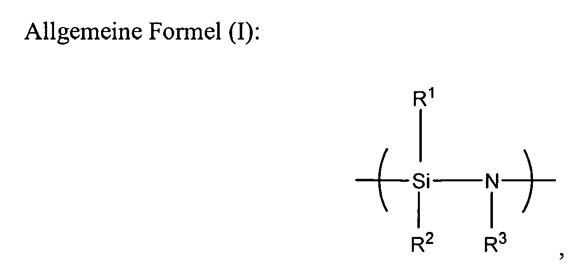 worin R¹, R² und R³ jeweils und unabhängig steht für ein Wasserstoffatom, eine Alkylgruppe, eine Alkenylgruppe, eine Cycloalkylgruppe, eine Arylgruppe, eine Gruppe anders als diese Gruppen, in welcher der Teil, der direkt an Silicium oder Stickstoff gebunden ist, Kohlenstoff ist, eine Alkylsilylgruppe, eine Alkylaminogruppe oder eine Alkoxygruppe;
Allgemeine Formel (II): - (SiR⁴(NR⁵)_{1.5})ₙ -,
worin R⁴ und R⁵ jeweils und unabhängig steht für ein Wasserstoffatom, eine Alkylgruppe, eine Alkenylgruppe, eine Cycloalkylgruppe, eine Arylgruppe, eine Gruppe anders als diese Gruppen, in welcher der Teil, der direkt an ein Silicium oder Stickstoff gebunden ist, Kohlenstoff ist, eine Alkylsilylgruppe, eine Alkylaminogruppe oder eine Alkoxygruppe, und n eine beliebige ganze Zahl ist.

2. Lichtempfindliche Polysilazan-Zusammensetzung gemäß Anspruch 1, worin das Polysilazan-Modifizierungsprodukt Polyorganosiloxazan mit einem Zahlenmittel des Molekulargewichts von 300 bis 100 000 ist, welches als seine Hauptwiederholungseinheit -(RSiN₃)-, -(RSiN₂O)-, -(RSiNO₂)- und -(RSiO₃)-enthält, (worin R eine Alkylgruppe, Alkenylgruppe, Cycloalkylgruppe, Arylgruppe, Alkylaminogruppe oder Alkylsilylgruppe ist).

3. Lichtempfindliche Polysilazan-Zusammensetzung gemäß Anspruch 1 oder 2, worin das Peroxid tert.-Butylperoxybenzoat 3, 3',4,4'-Tetra(t-butylperoxycarbonyl)benzophenon oder α,α'-Bis(t-butylperoxy)diisopropylbenzol ist.

4. Lichtempfindliche Polysilazan-Zusammensetzung gemäß einem der Ansprüche 1 bis 3, welches zusätzlich einen Sensibilisierungsfarbstoff enthält.

5. Lichtempfindliche Polysilazan-Zusammensetzung gemäß Anspruch 4, worin der Sensibilisierungsfarbstoff ausgewählt ist aus Cumarin, Ketocumarin und deren Derivate und Thiopyryliumsalzen.

6. Lichtempfindliche Polysilazan-Zusammensetzung gemäß einem der Ansprüche 4 oder 5, worin diese zusätzlich einen Oxidationskatalysator enthält.

7. Lichtempfindliche Polysilazan-Zusammensetzung gemäß Anspruch 6 worin, besagter Oxidationskatalysator Palladiumpropionat ist.

8. Verfahren zur Ausbildung einer gemusterten Polysilazanschicht umfassend: einen Schritt, in welchem eine Überzugsschicht aus einer lichtempfindlichen olysilazan-Zusammensetzung, umfassend ein Polysilazan und ein Photosäure-Erzeuger, gemäß einem beliebigen der Ansprüche 1 bis 7 ausgebildet wird, einen Schritt, in welchem die Überzugsschicht Licht in einem Muster ausgesetzt wird, und einen Schritt, in welchem der ausgesetzte Teil der Überzugsschicht abgelöst wird.

9. Verfahren gemäß Anspruch 8, worin der Ablösungsschritt unter Verwendung einer schwach alkalischen wässrigen Lösung durchgeführt wird.

10. Verfahren zur Ausbildung einer gemusterten Isolierschicht enthaltend einen Schritt, in welchem eine gemusterte Polysilazanschicht, die durch das Verfahren gemäß Anspruch 8 gebildet worden ist, umgesetzt wird zu einer siliziumbasierten Keramikschicht durch Stehenlassen der Schicht in einer Umgebungsatmosphäre oder durch Backen der Schicht.

## Revendications

1. Composition photosensible à base de polysilazane comprenant un polysilazane et un générateur de photoacides destinée à former un film isolant à motifs par conversion en céramique ; dans laquelle ledit polysilazane est un polysilazane, ou un de ses produits de modification ayant un poids moléculaire moyen en nombre allant de 100 à 50 000, contenant principalement le squelette représenté par la formule générale (I) suivante ou un polysilazane ayant un poids moléculaire moyen en nombre allant de 100 à 100 000 contenant principalement le squelette représenté par la formule générale (II) suivante, et ledit générateur de photoacides est un peroxyde : Formule générale (I) : 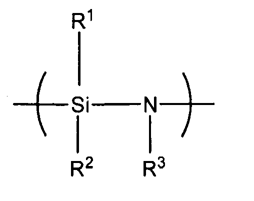 dans laquelle, R¹, R² et R³ représentent respectivement et indépendamment un atome d'hydrogène, un groupe alkyle, un groupe alcényle, un groupe cycloalkyle, un groupe aryle, un groupe autre que ces groupes dans lequel la partie directement liée au silicium ou à l'azote est un carbone, un groupe alkylsilyle, un groupe alkylamino ou un groupe alcoxy ;
Formule générale (II) : -(SiR⁴(NR⁵)_{1.5})ₙ-
dans laquelle, R⁴ et R⁵ représentent respectivement et indépendamment un atome d'hydrogène, un groupe alkyle, un groupe alcényle, un groupe cycloalkyle, un groupe aryle, un groupe autre que ces groupes dans lequel la partie directement liée au silicium ou à l'azote est un carbone, un groupe alkylsilyle, un groupe alkylamino ou un groupe alcoxy, et n représente un entier arbitraire.

2. Composition photosensible à base de polysilazane selon la revendication 1, dans laquelle ledit produit de modification du polysilazane est un polyorganosiloxazane ayant un poids moléculaire moyen en nombre allant de 300 à 100 000 et contenant comme unité récurrente principale -(RSiN₃)-, -(RSiN₂O)-, -(RSiNO₂)- et -(RSiO₃)-(dans lesquelles R représente un groupe alkyle, un groupe alcényle, un groupe cycloalkyle, un groupe aryle, un groupe alkylamino ou un groupe alkylsilyle).

3. Composition photosensible à base de polysilazane selon la revendication 1 ou 2, dans laquelle ledit peroxyde est le peroxybenzoate de t-butyle, la 3,3',4,4'-tétra(t-butylperoxycarbonyl)benzophénone ou le α,α'-bis(*t*-butylperoxy)diisopropylbenzène.

4. Composition photosensible à base de polysilazane selon l'une quelconque des revendications 1 à 3, contenant en outre un colorant sensibilisateur.

5. Composition photosensible à base de polysilazane selon la revendication 4, dans laquelle ledit colorant sensibilisateur est choisi parmi la coumarine, une cétocoumarine et leurs dérivés et leurs sels thiopyrylium.

6. Composition photosensible à base de polysilazane selon l'une quelconque des revendications 4 ou 5, contenant en outre un catalyseur d'oxydation.

7. Composition photosensible à base de polysilazane selon la revendication 6, dans laquelle ledit catalyseur d'oxydation est le propionate de palladium.

8. Procédé de formation d'un film de polysilazane à motifs comprenant : une étape dans laquelle un film de revêtement est formé à partir d'une composition photosensible à base de polysilazane comprenant un polysilazane et un générateur de photoacides selon l'une quelconque des revendications 1 à 7, une étape dans laquelle ledit film de revêtement est exposé à la lumière suivant un motif, et une étape dans laquelle la partie exposée dudit film de revêtement est dissoute.

9. Procédé selon la revendication 8, dans lequel ladite étape de dissolution est réalisée en utilisant une solution aqueuse faiblement alcaline.

10. Procédé de formation d'un film isolant à motifs contenant une étape dans laquelle un film de polysilazane à motifs formé par le biais du procédé selon la revendication 8 est converti en un revêtement céramique à base de silice en laissant le film à atmosphère ambiante ou en durcissant le film.
